(19) Europäisches Patentamt / European Patent Office / Office européen des brevets

(11) **EP 4 712 132 A1**

(12) **EUROPEAN PATENT APPLICATION**
published in accordance with Art. 153(4) EPC

(43) Date of publication:
**18.03.2026 Bulletin 2026/12**

(21) Application number: **24803550.3**

(22) Date of filing: **10.05.2024**

(51) International Patent Classification (IPC):
*H01L 23/02* (2006.01)    *G21F 1/10* (2006.01)
*G21F 3/00* (2006.01)    *H05K 9/00* (2006.01)

(52) Cooperative Patent Classification (CPC):
Y02E 30/10

(86) International application number:
**PCT/JP2024/017539**

(87) International publication number:
**WO 2024/232442 (14.11.2024 Gazette 2024/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **11.05.2023  JP 2023078396**
**09.05.2024  JP 2024076763**

(71) Applicants:
• **Dexerials Corporation**
**Shimotsuke-shi, Tochigi 323-0194 (JP)**
• **University of Tsukuba**
**Ibaraki 305-8577 (JP)**

(72) Inventors:
• **AIZAWA, Shun**
**Shimotsuke-shi, Tochigi 323-0194 (JP)**
• **KATSUTA, Yuma**
**Shimotsuke-shi, Tochigi 323-0194 (JP)**
• **TOZUNE, Midori**
**Shimotsuke-shi, Tochigi 323-0194 (JP)**
• **YAGIHASHI, Kazuhiro**
**Shimotsuke-shi, Tochigi 323-0194 (JP)**
• **HASEGAWA, Hiroshi**
**Shimotsuke-shi, Tochigi 323-0194 (JP)**
• **KONDO, Takahiro**
**Tsukuba-shi, Ibaraki 305-8577 (JP)**

(74) Representative: **Ter Meer Steinmeister & Partner Patentanwälte mbB**
**Nymphenburger Straße 4**
**80335 München (DE)**

(54) **NEUTRON RADIATION SHIELDING MATERIAL, SHIELDING MATERIAL FOR SEMICONDUCTOR DEVICE, PACKAGE FOR SEMICONDUCTOR DEVICE, SHIELDING MATERIAL FOR NUCLEAR REACTOR, NUCLEAR REACTOR CONTAINMENT VESSEL, NUCLEAR REACTOR BUILDING, SHIELDING MATERIAL FOR NUCLEAR FUSION REACTOR, NUCLEAR FUSION REACTOR, AND NUCLEAR FUSION REACTOR BUILDING**

(57)    A neutron radiation shielding material includes a boride having an average particle diameter of 500 μm or less. The neutron radiation shielding material shields neutron radiation.

Processed by Luminess, 75001 PARIS (FR)

**Description**

TECHNICAL FIELD

The present invention relates to a neutron radiation shielding material, a shielding material for a semiconductor device, a package for a semiconductor device, a shielding material for a nuclear reactor, a nuclear reactor containment vessel, a nuclear reactor building, a shielding material for a nuclear fusion reactor, a nuclear fusion reactor, and a nuclear fusion reactor building.

BACKGROUND ART

There is a demand for an increase in both capacity and performance of communication devices, which support information communication, to process communication traffic that has been increasing year by year, and semiconductor devices used for such communication devices are increasingly integrated and miniaturized. With such high integration and miniaturization of semiconductor devices, soft errors (temporary malfunctions in which neutrons radiated from the universe collide with silicon nuclei that makes up a semiconductor device to generate electrically charged particles, causing bit flipping in the capacitance of the capacitor in the semiconductor memory) tend to increase.

In order to inhibit such soft errors, there are techniques for correcting errors, such as hardware autonomous correction (error correction code (ECC) circuits), device autonomous correction (control programs), and the like. However, the time required for checking errors dominates the process of the error correction, causing a fatal delay in communication devices, autonomous driving devices, or the like, for which a high-speed computation or low-delay communication is imperative.

Considering the above, as techniques of shielding neutron radiation, there are methods, such as a method of using a material for decelerating neutron radiation in a semiconductor device, a method of reducing an area of a semiconductor device through three-dimensional structuring, a method of absorbing generated electric charges by dummy circuits, and the like.

For example, Patent Documents 1 and 2 disclose a technique of shielding neutron radiation with an epoxy resin composition for shielding a semiconductor, in which the epoxy resin composition includes an epoxy resin, a curing agent, and an inorganic filler, such as gadolinium oxide or the like.

Further, when humans are exposed to neutron radiation, the neutrons collide with hydrogen nuclei (protons) in water, which makes up 70% of the human body. The protons collided with neutrons are knocked off to cause dissociation or ionization in the body, which destroys molecules constituting cells and induces various disorders. Environments exposed to neutron radiation include environments inside nuclear power plants, nuclear fusion reactors, neutron generators, inside spacecrafts, and the like. Materials of housings that cover the foregoing environments need to be selected carefully considering potential adverse effects to the human body.

Patent Document 3 discloses a technique of integrating two identically-shaped cement mortar slabs or two identically-shaped concrete slabs with a paraffin layer interposed between the cement mortar slabs or concrete slabs, thereby constituting a radiation shielding laminate material. Each cement mortar slab includes cement, sand, and glass cullet. Each concrete slab further includes coarse aggregate in addition to the materials of the cement mortar slab. The paraffin layer has the same shape as the cement mortar slabs or concrete slabs.

CITATION LIST

PATENT DOCUMENTS

Patent Document 1: Japanese Unexamined Patent Application Publication No. 2021-178953
Patent Document 2: Japanese Unexamined Patent Application Publication No. 2021-181559
Patent Document 3: Japanese Unexamined Patent Application Publication No. 2014-137361

SUMMARY OF THE INVENTION

TECHNICAL PROBLEM

However, the techniques of shielding neutron radiation in the related art use a large amount of a material for decelerating neutron radiation, and neutron radiation cannot be sufficiently shielded unless a thickness of a member using the material is increased.

An object of the present invention is to provide a neutron radiation shielding material that can efficiently shield neutron radiation.

SOLUTION TO THE PROBLEM

A neutron radiation shielding material according to the present invention includes a boride having an average particle diameter of 500 $\mu$m or less, and shields neutron radiation.

EFFECTS OF THE INVENTION

According to the present invention, a neutron radiation shielding material that can efficiently shield neutron radiation can be provided.

BRIEF DESCRIPTION OF THE DRAWINGS

[Fig. 1] Fig. 1 is a graph illustrating a relationship between energy of neutron radiation and a soft error rate.
[Fig. 2] Fig. 2 is a graph illustrating the particle size distribution of the neutron radiation shielding material of the present embodiment.
[Fig. 3] Fig. 3 is an SEM image illustrating the particle size of the primary particle of the neutron radiation shielding material of the present embodiment.
[Fig. 4] Fig. 4 is an SEM image illustrating the particle size of the secondary particle of the neutron radiation shielding material of the present embodiment.
[Fig. 5] Fig. 5 is a view illustrating one example of a semiconductor device for which the neutron radiation shielding material of the present embodiment is applied.
[Fig. 6] Fig. 6 is a view illustrating one example of a nuclear reactor facility for which the neutron radiation shielding material of the present embodiment is applied.
[Fig. 7] Fig. 7 is a view illustrating one example of a nuclear fusion reactor facility for which the neutron radiation shielding material of the present embodiment is applied.
[Fig. 8] Fig. 8 is a graph illustrating the result of the neutron radiation shielding simulation when the radiation source is neutron radiation at 0.5 eV.
[Fig. 9] Fig. 9 is a graph illustrating the result of the neutron radiation shielding simulation when the radiation source is neutron radiation at 10 keV.
[Fig. 10] Fig. 10 is a graph illustrating the result of the neutron radiation shielding simulation when the radiation source is neutron radiation at 14 MeV.
[Fig. 11] Fig. 11 is a graph illustrating the result of the neutron radiation shielding simulation when the radiation source is neutron radiation at 100 MeV.
[Fig. 12] Fig. 12 is a graph illustrating the result of the radiation shielding simulation when the radiation source is neutron radiation at 0.5 eV.
[Fig. 13] Fig. 13 is a graph illustrating the result of the radiation shielding simulation when the radiation source is neutron radiation at 10 keV.
[Fig. 14] Fig. 14 is a graph illustrating the result of the secondary radiation generation simulation when the radiation source is neutron radiation at 14 MeV.
[Fig. 15] Fig. 15 is a graph illustrating the result of the secondary radiation generation simulation when the radiation source is neutron radiation at 100 MeV.
[Fig. 16] Fig. 16 is a graph illustrating the result of the radiation shielding simulation when the radiation source is $\alpha$ rays at 14 MeV.
[Fig. 17] Fig. 17 is a graph illustrating the result of the secondary radiation shielding simulation when a radiation source is neutron radiation at 0.5 eV.
[Fig. 18] Fig. 18 is a graph illustrating the result of the secondary radiation generation simulation when the radiation source is neutron radiation at 10 keV.
[Fig. 19] Fig. 19 is a graph illustrating the result of the secondary radiation generation simulation when the radiation source is $\alpha$ rays at 14 MeV.
[Fig. 20] Fig. 20 is a graph illustrating the result of the secondary radiation ($\alpha$ rays) generation simulation when the radiation source is neutron radiation at 0.5 eV.
[Fig. 21] Fig. 21 is a graph illustrating the result of the secondary radiation ($\alpha$ rays) generation simulation when the radiation source is neutron radiation at 10 keV.

[Fig. 22] Fig. 22 is a graph illustrating the result of the secondary radiation ($\alpha$ rays) generation simulation when the radiation source is neutron radiation at 14 MeV.

[Fig. 23] Fig. 23 is a graph illustrating the result of the secondary radiation ($\alpha$ rays) generation simulation when the radiation source is neutron radiation at 100 MeV.

DESCRIPTION OF EMBODIMENTS

Hereinafter, embodiments of the present invention will be described with reference to drawings, as needed.

The neutron radiation shielding material of the present embodiment shields neutron radiation. The neutron radiation shielding material of the present embodiment can constitute, for example, a shielding material for a semiconductor device, which can shield neutron radiation applied to a semiconductor device.

The neutron is a neutral particle that has substantially the same mass as a proton, and does not have a charge. The neutrons are included in cosmic rays. The phrase "shielding neutron radiation" refers to attenuation or absorption of neutron radiation. In the present specification, the energy region of the neutron radiation shielded by the neutron radiation shielding material of the present embodiment is the energy region of 100 MeV or less, which also includes a low energy region of 0.1 MeV or less.

In the present specification, a semiconductor device refers to a memory or a device in which the circuits are integrated on a silicon substrate, and the memory is mounted on the integrated-circuit silicon substrate. The memory is a memory, such as a static random access memory (SRAM), a dynamic random access memory (DRAM), NAND flash (volatile or nonvolatile), and the like. The integrated circuit is an integrated circuit, such as a field programmable gate array (FPGA), a system on a chip (SoC), and the like.

The neutron radiation shielding material of the present embodiment includes a boride. The boride refers to a compound that includes boron (B) and an element having smaller electronegativity than the boron. The boron constituting the boride typically has a minus charge. In addition, when boron constituting the boride collides with neutrons of the neutron radiation, the following reaction is induced, thereby decomposing the boron into lithium (Li) atoms and $\alpha$ rays, causing attenuation of the neutron radiation.

[Math. 1]

$$^{10}B + n \longrightarrow {}^{7}Li + \alpha$$

$$(n: \text{neutron}, \ \alpha: \alpha \ \text{ray})$$

Examples of the boride include: hydrogen boride such as borophane; metal borides, such as yttrium boride, titanium boride, and chromium boride; and the like. The above borides may be used alone or in combination.

Among the above borides, hydrogen boride is preferable. The hydrogen boride is a hydride compound of boron (B), which is represented by a general formula: $H_nB_m$ (m and n are each an integer of 1 or greater). A molar ratio between boron (B) and hydrogen (H) in the hydrogen boride may be any ratio. The preferred hydrogen boride is borophane (HB) in which a molar ratio of boron to hydrogen is 1:1.

Since the atomic nucleus (proton) of hydrogen constituting the hydrogen boride has almost the same size as a neutron, the hydrogen can decelerate neutron radiation when the hydrogen collides with radiated neutrons. In addition, the boron constituting the hydrogen boride can decelerate neutron radiation as described above. The hydrogen boride can efficiently attenuate the neutron radiation owing to the above characteristics.

The hydrogen boride has a two-dimensional network containing boron atoms and hydrogen atoms, and may have a mesh-like two-dimensional network in which the boron atoms are arranged in hexagonal rings, and the hexagons formed with the boron atoms are linked with with one another. In addition, the hydrogen boride may have a mesh-like two-dimensional network in which the boron atoms are arranged into pentagonal to heptagonal rings, and the pentagons, hexagons, or heptagons formed with the boron atoms are linked one another.

Since the neutron radiation shielding material of the present embodiment includes the above-described boride, the neutron radiation shielding material can shield neutron radiation more efficiently. Thus, soft errors, which may be caused in the semiconductor device by neutron radiation applied to the semiconductor device, can be inhibited by a shielding material for a semiconductor, which is composed of the neutron radiation shielding material of the present embodiment.

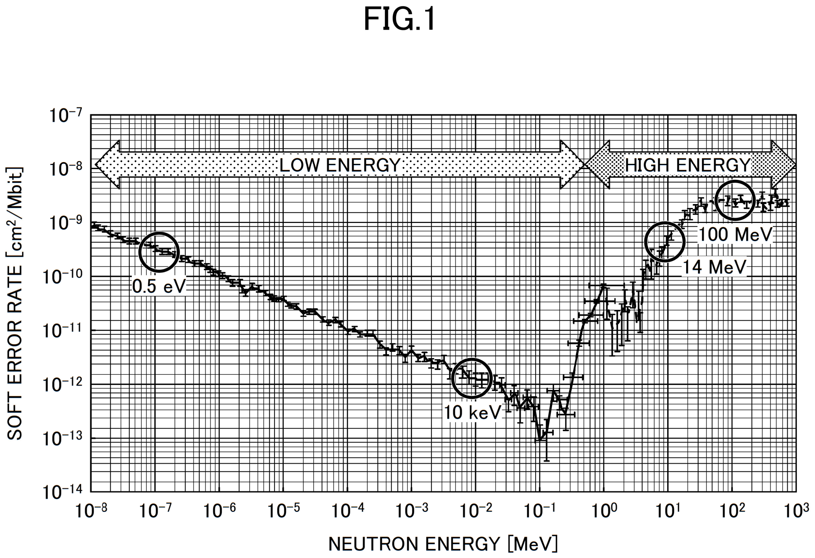

Recent studies have revealed that soft errors of a semiconductor device tend to increase even in the energy region of 0.1 MeV or less (see, Fig. 1, https://pc.watch.impress.co.jp/docs/news/1486438.html).

Considering the above, the neutron radiation shielding material of the present embodiment can sufficiently shield the neutron radiation in low energy region (0.1 MeV or less) because the neutron radiation shielding material includes the boride that can efficiently attenuate the neutron radiation. Therefore, soft errors, which are increased by applied neutron radiation in the low energy region, can also be inhibited.

Further, in the case where the boride included in the neutron radiation shielding material is hydrogen boride, the density of the neutron radiation shielding material of the present embodiment can be increased. The density of the neutron radiation shielding material is not particularly limited, but the density of the neutron radiation shielding material is, for example, 0.94 g/cm$^3$ or greater, preferably 0.96 g/cm$^3$ or greater, and more preferably 0.98 g/cm$^3$ or greater. The upper limit of the density of the neutron radiation shielding material is not particularly limited. In view of processability of the neutron radiation shielding material, the upper limit of the density is 2 g/cm$^3$ or less.

When the density of the neutron radiation shielding material is 0.94 g/cm$^3$ or greater, neutron radiation can be efficiently shielded without increasing the thickness of the neutron radiation shielding material. Therefore, the neutron radiation shielding material of the present embodiment can sufficiently shield neutron radiation even in a sheet shape or a film shape. Further, soft errors, which are caused by neutron radiation applied to the semiconductor device, can be inhibited by a shielding material for a semiconductor composed of the above neutron radiation shielding material.

The form of the neutron radiation shielding material of the present embodiment is not particularly limited, but is preferably a powder. When the form of the neutron radiation shielding material is a powder, the neutron radiation shielding material is easily molded.

A particle size of the neutron radiation shielding material of the present embodiment is not particularly limited, but the particle size is preferably 500 μm or less, more preferably 400 μm or less, and yet more preferably 300 μm or less. Although the lower limit of the particle size may be any size, the practicable lower limit is preferably 0.1 μm or greater, more preferably 1 μm or greater, and yet more preferably 2 μm or greater.

In the present specification, the particle size refers to an average particle diameter defined by a median diameter (D50). The particle size may be a particle size of primary particles, or a particle size of secondary particles.

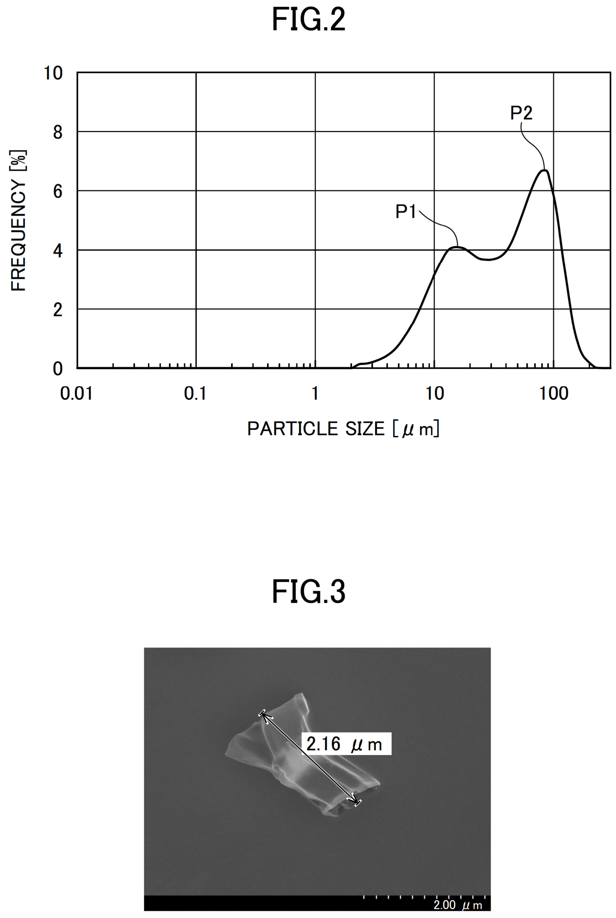

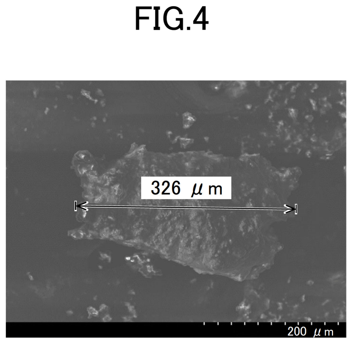

Fig. 2 is a graph illustrating a particle size distribution of the neutron radiation shielding material of the present embodiment. Fig. 3 is an SEM image illustrating a particle size of a primary particle of the neutron radiation shielding material of the present embodiment. Fig. 4 is an SEM image illustrating a particle size of a secondary particle of the neutron radiation shielding material of the present embodiment. In Fig. 2, P1 represents a peak of primary particles, and P2 represents a peak of secondary particles.

According to Figs. 2 and 3, in the case where a powder of the neutron radiation shielding material is composed of primary particles, the particle size of the primary particles is 0.1 μm or greater and 100 μm or less, preferably 1 μm or greater and 50 μm or less, and more preferably 2 μm or greater and 30 μm or less. According to Figs. 2 and 4, in the case where a powder of the neutron radiation shielding material is composed of secondary particles, the particle size of the secondary particles is 20 μm or greater and 500 μm or less, preferably 30 μm or greater and 300 μm or less, and more preferably 50 μm or greater and 200 μm or less.

When the particle size of the neutron radiation shielding material of the present embodiment is 500 μm or less, the density of the neutron radiation shielding material can be increased, and neutron radiation can be efficiently shielded.

Since the neutron radiation shielding material of the present embodiment includes the boride having the particle size of 500 μm or less, the density of the neutron radiation shielding material can be increased, and neutron radiation in the low energy region (0.1 MeV or less) can also be sufficiently shielded. Therefore, soft errors, which may be increased by applied neutron radiation in the low energy region, can be inhibited by the neutron radiation shielding material of the present embodiment.

The shape of the neutron radiation shielding material of the present embodiment is not particularly limited. As described above, the shape of the neutron radiation shielding material can be a sheet shape or a film shape, because neutron radiation can be efficiently shielded. Since the shape of the neutron radiation shielding material is a sheet shape or a film shape, a semiconductor device can be made compact while shielding neutron radiation.

In the case where the shape of the neutron radiation shielding material is a sheet shape, the thickness of the neutron radiation shielding material is not particularly limited, but the thickness is preferably 1 nm or greater and 1,000 μm or less, more preferably 10 nm or greater and 800 μm or less, and yet more preferably 100 nm or greater and 500 μm or less. When the thickness of the neutron radiation shielding material having a sheet shape is 1 nm or greater and 1,000 μm or less, the amount of the neutron radiation shielding material used can be reduced. In addition, a member using the neutron radiation shielding material can be made compact.

Although the neutron radiation shielding material of the present embodiment can have any thickness, the attenuation ratio of the neutron radiation at 0.5 eV is 1e-2 or less, preferably 5e-3 or less, and more preferably 1e-3 or less, when the thickness of the neutron radiation shielding material is 1 cm.

In the present specification, neutron radiation at 0.5 eV refers to neutron radiation having the energy level of 0.5 eV. The attenuation ratio of the neutron radiation refers to a ratio N2/N1 of a dose N2 of the neutron radiation after passing through the shielding material in the thickness direction to a dose N1 of the neutron radiation before passing through the shielding material in the thickness direction.

When the thickness of the neutron radiation shielding material is 1 cm, the attenuation ratio of the neutron radiation at 0.5 eV is not particularly limited, but the practicable lower limit is 1e-7 or greater, more preferably 5e-7 or greater, and yet more preferably 1e-6 or greater.

When the thickness of the neutron radiation shielding material of the present embodiment is 5 cm, the attenuation ratio of the neutron radiation at 0.5 eV is 1e-3 or less, more preferably 5e-4 or less, and yet more preferably 1e-4 or less. When the thickness of the neutron radiation shielding material is 5 cm, the lower limit of the attenuation ratio of the neutron radiation at 0.5 eV is not particularly limited, but the practicable lower limit is 5e-8 or greater, more preferably 1e-7 or greater, and yet more preferably 5e-7 or greater.

When the thickness of the neutron radiation shielding material of the present embodiment is 10 cm, the attenuation ratio of the neutron radiation at 10 keV is 5e-3 or less, preferably 1e-3 or less, and more preferably 5e-4 or less. When the thickness of the neutron radiation shielding material is 10 cm, the lower limit of the attenuation ratio of the neutron radiation at 10 eV is not particularly limited, but the practicable lower limit is 5e-6 or greater, more preferably 1e-5 or greater, and yet more preferably 5e-5 or greater.

When the thickness of the neutron radiation shielding material of the present embodiment is 100 cm, the attenuation ratio of the neutron radiation at 14 MeV is 1e-3 or less, preferably 9e-4 or less, and more preferably 8e-4 or less. When the thickness of the neutron radiation shielding material is 100 cm, the lower limit of the attenuation ratio of the neutron radiation at 14 eV is not particularly limited, but the practicable lower limit is 5e-6 or greater, more preferably 1e-5 or greater, and yet more preferably 5e-5 or greater.

Since the attenuation ratio of the neutron radiation at 0.5 eV is 1e-2 or less when the thickness of the neutron radiation shielding material of the present embodiment is 1 cm as described above, the neutron radiation can be efficiently shielded. Thus, soft errors, which may be caused in the semiconductor device by the neutron radiation applied to the semiconductor device, can be inhibited by a shielding material for a semiconductor device, which is composed of the neutron radiation shielding material of the present embodiment.

Since the attenuation ratio of the neutron radiation at 0.5 eV is 1e-2 or less when the thickness of the neutron radiation shielding material of the present embodiment is 1 cm, the neutron radiation in the energy region of 100 MeV or less can be sufficiently shielded.

Since the attenuation ratio of the neutron radiation at 0.5 eV is 1e-2 or less when the thickness of the neutron radiation shielding material of the present embodiment is 1 cm, the neutron radiation in the low energy region (0.1 MeV or less) can also be sufficiently shielded. Therefore, soft errors, which may be increased by applied neutron radiation in the low energy region, can be also inhibited by the neutron radiation shielding material.

Since the attenuation ratio of the neutron radiation at 0.5 eV is 1e-3 or less when the thickness of the neutron radiation shielding material of the present embodiment is 5 cm, the neutron radiation can be more efficiently shielded. Therefore, soft errors, which may be caused in the semiconductor device by the neutron radiation applied to the semiconductor device, can be inhibited at high precision by a shielding material for a semiconductor device, which is composed of the neutron radiation shielding material of the present embodiment.

Since the attenuation ratio of the neutron radiation at 10 keV is 5e-3 or less when the thickness of the neutron radiation shielding material of the present embodiment is 10 cm, the neutron radiation can be yet more efficiently shielded. Therefore, soft errors, which may be caused in the semiconductor device by the neutron radiation applied to the semiconductor device, can be inhibited at higher precision by a shielding material for a semiconductor device, which is composed of the neutron radiation shielding material of the present embodiment.

Since the attenuation ratio of the neutron radiation at 14 MeV is 1e-3 or less when the thickness of the neutron radiation shielding material of the present embodiment is 100 cm, the neutron radiation can be yet more efficiently shielded. Thus, soft errors, which may be caused in the semiconductor device by the neutron radiation applied to the semiconductor device, can be inhibited at yet higher precision by a shielding material for a semiconductor device, which is composed of the neutron radiation shielding material of the present embodiment.

In addition, since the neutron radiation shielding material of the present embodiment includes the boride as described above, $\alpha$ rays at 1 MeV can be shielded when the thickness of the neutron radiation shielding material is 0.1 cm. In the present specification, $\alpha$ rays at 1 MeV refer to $\alpha$ rays having the energy level of 1 MeV. The $\alpha$ rays shielded by the neutron radiation shielding material may be primary radiation or secondary radiation.

The primary radiation is radiation directly emitted from a radiation source. The secondary radiation is radiation generated by the interaction between radiation (primary radiation) directly emitted from a radiation source and a substance.

Since the neutron radiation shielding material of the present embodiment shields $\alpha$ rays at 1 MeV when the thickness of the neutron radiation shielding material is 0.1 cm, $\alpha$ rays that are radioactive rays other than neutron radiation can also be efficiently shielded without increasing the thickness of the neutron radiation shielding material.

Since the neutron radiation shielding material of the present embodiment includes the boride as described above, the neutron radiation shielding material having the thickness of 0.1 cm does not generate secondary $\alpha$ rays when neutron radiation at 10.0 keV is applied.

Since the neutron radiation shielding material of the present embodiment does not generate secondary $\alpha$ ray when the thickness of the neutron radiation shielding material is 0.1 cm even when neutron radiation of 10.0 keV is applied, generation of the secondary radiation can be inhibited without increasing the thickness of the neutron radiation shielding material.

The amount of the boride in the neutron radiation shielding material of the present embodiment is not particularly limited, but is preferably 5 percent by mass or greater, more preferably 7 percent by mass or greater, and yet more preferably 10 percent by mass or greater. The upper limit of the amount of the boride is not particularly limited, and may be 100 percent by mass at the maximum.

In the case where the boride is converted to boron (B), the amount of the boron (B) included in the neutron radiation shielding material of the present embodiment is preferably 4 percent by mass or greater, more preferably 6 percent by mass or greater, and yet more preferably 9 percent by mass or greater. The upper limit of the amount of the boron (B) is not particularly limited, and may be 95 percent by mass at the maximum.

When the amount of the boride in the neutron radiation shielding material is 5 percent by mass or greater, reduction in the function of shielding neutron radiation can be minimized because a large amount of boron atoms is included in the neutron radiation shielding material. When the amount of the boron in the neutron radiation shielding material is 4 percent by mass or greater based on the boron (B) converted from the boride, reduction in the function of shielding neutron radiation can be minimized.

The neutron radiation shielding material of the present embodiment may further include a resin. When the neutron radiation shielding material of the present embodiment includes the resin, the neutron radiation shielding material can be easily molded. Since the neutron radiation shielding material includes the resin having flexibility, adhesion, and the like, the neutron radiation shielding material can be easily mounted on a semiconductor device.

A material of the resin is not particularly limited. Examples of the material of the resin include polyolefin-based resins, such as polyethylene-based resins, polypropylene-based resins, or the like, polyvinyl acetate-based resins, polystyrene-based resins, styrene-butadiene copolymers, styrene-maleic acid copolymers, vinylidene fluoride-based resins, polyvinyl alcohol-based resins, polybutadiene-based resins, polyester-based resins, silicone-based resins, polyamide-based resins, polyimide-based resins, alkyd-based resins, epoxy-based resins, unsaturated polyester-based resins, thermoset poly(meth)acrylic resins, melamine-based resins, urea-based resins, phenol-based resins, xylene-based resins, maleic acid resins, rubber-based resins, such as chlorinated rubber, cyclized rubber, or the like, petroleum-based resins, and natural resins, such as casein and the like. Among the above resins, polyethylene-based resins and polyimide-based resins are preferable because the neutron radiation shielding material is easily molded, and the neutron radiation shielding material is easily mounted on a semiconductor device.

When the resin in the neutron radiation shielding material of the present embodiment is a polyolefin-based resin, the polyolefin-based resin includes hydrogen so that neutron radiation can be assuredly decelerated.

When the resin is a polyimide-based resin, the neutron radiation shielding material can be used in a high temperature environment because the polyimide-based resin has high heat resistance. In addition, the neutron radiation shielding material using the polyimide-based resin can have a low thermal shrinkage ratio because the polyimide-based resin has a low thermal expansion coefficient.

An amount of the resin in the neutron radiation shielding material of the present embodiment is not particularly limited, but the amount of the resin is preferably 95 percent by mass or less, more preferably 93 percent by mass or less, and yet more preferably 90 percent by mass or less. The lower limit of the amount of the resin is not limited, and may be 0 percent by mass at the minimum. When the amount of the resin is 95 percent by mass or less, the amount of the boride capable of attenuating neutron radiation can be secured.

In the case where the neutron radiation shielding material of the present embodiment includes the above resin, the neutron radiation shielding material may be configured as a layer stack in which at least a first layer including the boride and a second layer including the resin are stacked.

The first layer including the boride may include a resin, and the second layer including the resin may include boride. The layer stack in which at least the first layer and the second layer are stacked may be formed only with the first layer and the second layer, or may be formed by stacking multiple first layers and multiple second layers. In addition, a third layer may be stacked in addition to the first layer and the second layer.

Since the neutron radiation shielding material of the present embodiment is configured as the above layer stack in which at least the first layer including the boride and the second layer including the resin are stacked, neutron radiation is attenuated mainly by the first layer, and the second layer can protect the first layer. By adding an adhesive resin to the second layer or the like, the neutron radiation shielding material can be easily mounted via the second layer.

Since the neutron radiation shielding material of the present embodiment has the above configuration and effects, the neutron radiation shielding material can be suitably applied for uses requiring shielding of neutron radiation. Examples of applicable uses of the neutron radiation shielding material of the present embodiment include: semiconductor devices; electronic devices using semiconductor devices; nuclear reactor facilities, such as nuclear reactor pressure vessels, nuclear reactor containment vessels, nuclear reactor buildings, and the like; nuclear fusion reactor facilities, such as nuclear fusion reactors, nuclear fusion reactor buildings, and the like; neutron generators; spacecrafts; and the like.

Examples of the application of the neutron radiation shielding material of the present embodiment will be described hereinafter.

<First embodiment>

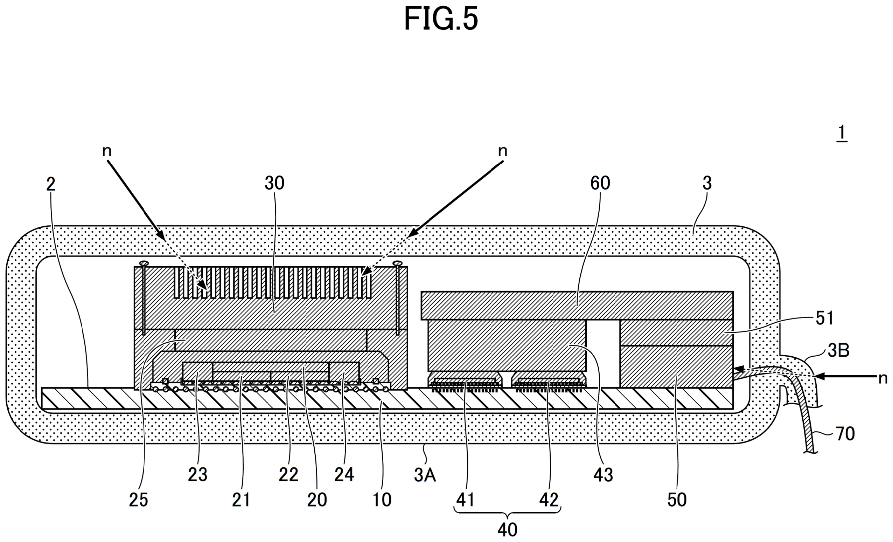

Fig. 5 illustrates one example of a semiconductor device including a package for a semiconductor device for which the neutron radiation shielding material of the present embodiment is applied. In the present embodiment, the package for the semiconductor device is a housing (case) in which a semiconductor element is accommodated.
In Fig. 5, the semiconductor device 1 includes a semiconductor element 2 and a housing 3.
The semiconductor element 2 includes a printed circuit board 10, SoC 21 to Soc 24 on which SRAM 20 is mounted, a heat sink 30, an FPGA die 40, an optical transceiver 50, a heat spreader 60, and a transmission cable 70. The transmission cable 70 is an optical fiber, a copper wire, a coaxial cable, or the like.
The printed circuit board 10 is formed of an insulating material. On the printed circuit board 10, the SoC 21 to 24 on which the SRAM 20 is mounted, the optical transceiver 50, and the heat spreader 60 are arranged.
The SRAM 20 is arranged above or in parallel with the cores 21 and 22 inside the SoC mounted on the printed circuit board 10. Further, the SRAM 20 is covered with thermal interface materials (TIM) 25 in a state in which the SRAM 20 is mounted as the SoC together with DRAMs, such as high bandwidth memory (HBM) 23 and 24. The heat sink 30 is arranged above the SRAM 20 with the TIM 25 being interposed between the heat sink 30 and the SRAM 20.
The FPGA die 40 is configured as silicon (Si) dies 41 and 42 arranged on the printed circuit board 10. The upper portions of the silicon dies 41 and 42 are covered with the TIM 43.
The optical transceiver 50 is arranged on the printed circuit board 10. The upper portion of the optical transceiver 50 is covered with the TIM 51.
The heat spreader 60 is arranged above the FPGA die 40 via the TIM 43, and above the optical transceiver 50 via TIM 51.
The transmission cable 70 is coupled to the optical transceiver 50, and extends outside the semiconductor device 1.
The housing 3 accommodates the semiconductor element 2, and covers the outer periphery of the semiconductor element 2. The semiconductor element 2 is disposed on the bottom 3A of the housing 3, and an insertion portion 3B from which the transmission cable 70 is inserted is provided on the side surface of the housing 3.
In the semiconductor device 1, the housing 3 is formed using the neutron radiation shielding material of the present embodiment. Specifically, the housing 3 includes the neutron radiation shielding material that includes a boride having a particle size of 500 $\mu$m or less. The housing 3 is one example of the package for the semiconductor device of the present embodiment.
The package for the semiconductor device of the present embodiment is not limited to the configuration of the housing 3 illustrated in Fig. 5. For example, the housing 3 may be composed of an insulating material or the like, which is different from a shielding material, and the housing 3 may be covered by the neutron radiation shielding material of the present embodiment. Alternatively, the neutron radiation shielding material of the present embodiment may be arranged only on the upper surface of the semiconductor die to shield only neutrons incident from a certain direction.
Since the package for the semiconductor device of the present embodiment is formed using the above-described neutron radiation shielding material, as described with the housing 3, the outer periphery of the semiconductor element 2 can be protected by the neutron radiation shielding material of the present embodiment in all directions. Thus, the neutron radiation incident on the housing 3 is shielded by the housing 3, and soft errors of the semiconductor device 1, in which the semiconductor element 2 is accommodated in the housing 3, can be inhibited.

<Second embodiment>

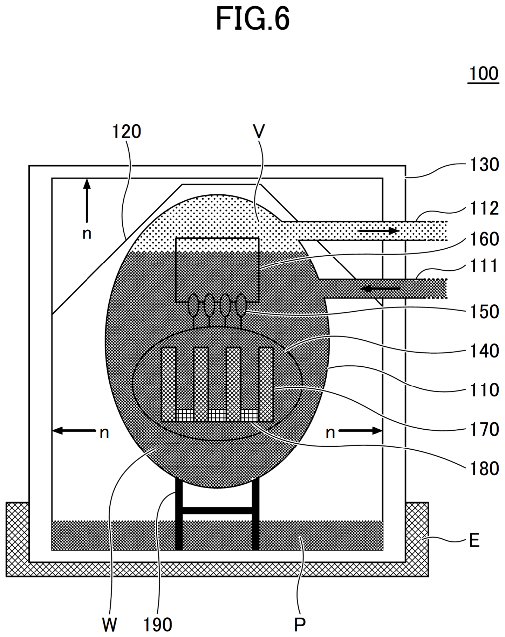

Fig. 6 illustrating one example of a nuclear reactor facility in which the neutron radiation shielding material of the present embodiment is applied as a shielding material for a nuclear reactor. The neutron radiation shielding material of the present embodiment can be configured as the shielding material for the nuclear reactor, which shields neutron radiation generated in a nuclear reactor. Specifically, the shielding material for the nuclear reactor of the present embodiment can be composed of the neutron radiation shielding material that includes boride, and has a particle size of 500 $\mu$m or less.
The nuclear reactor facility is a facility equipped with a nuclear reactor for generating nuclear power. In Fig. 6, the nuclear reactor facility 100 includes a nuclear reactor pressure vessel 110, a nuclear reactor containment vessel 120, and a nuclear reactor building 130.
The nuclear reactor pressure vessel 110 is a vessel that accommodates a core of the nuclear reactor. The nuclear reactor pressure vessel 110 accommodates a core shroud 140, a steam separator 150, and a steam dryer 160. The nuclear reactor pressure vessel 110 is filled with water W and a vapor V. The nuclear reactor pressure vessel 110 may accommodate nuclear reactor facility components other than the core shroud 140, the steam separator 150, and the steam dryer 160.

A water inlet 111 and an exhaust outlet 112 are provided at the upper portion of the nuclear reactor pressure vessel 110. The exhaust outlet 112 is arranged above the water inlet 111. Water W is supplied to the nuclear reactor pressure vessel 110 through the water inlet 111. The vapor generated inside the nuclear reactor pressure vessel 110 is discharged from the exhaust outlet 112.

The core shroud 140 constitutes a nuclear reactor core. The core shroud 140 accommodates fuel rods 170 and control rods 180.

The fuel rods 170 are a fuel assembly in which fuel cladding tubes, each filled with fuel pellets, such as uranium or the like, and sealed, are bundled together.

The control rods 180 are the facility components that control nuclear fission to adjust output of the nuclear reactor. The control rods are formed of a material absorbing neutron radiation, such as boron, cadmium, and the like. Fission occurs when neutron radiation strike uranium. The rate of fission can be adjusted by inserting and removing the control rods to change the number of neutrons in the reactor.

The steam separator 150 is disposed above the core shroud 140. The steam separator 150 imparts a swirling flow to the steam-water mixture vapor released from the core shroud 140, and separates the water toward outside and the steam toward inside by the centrifugal separation action, thereby separating the steam-water mixture vapor into the vapor and the saturated water. The separated saturated water is refluxed into the water W above the core shroud 140.

The steam dryer 160 is arranged above the steam separator 150. As the separated vapor passes through the steam dryer 160, fine water droplets included in the vapor are removed. The vapor from which the water droplets are removed is discharged from the exhaust outlet 112, and then is guided to a vapor turbine (not illustrated).

The nuclear reactor containment vessel 120 accommodates the nuclear reactor pressure vessel 110. A support member 190 is arranged on the bottom of the nuclear reactor containment vessel 120. The support member 190 fixes the lower portion of the core shroud 140. A pressure suppression pool P for inhibiting the pressure increase inside the nuclear reactor pressure vessel 110 due to the vapor pressure is provided at the bottom of the nuclear reactor containment vessel 120.

The nuclear reactor containment vessel 120 is, for example, formed of a reinforced concrete lined with steel liners. In the present embodiment, the nuclear reactor containment vessel 120 is formed using the shielding material for the nuclear reactor of the present embodiment. In this case, the shielding material for the nuclear reactor can be mixed with concrete constituting the nuclear reactor containment vessel 120.

The nuclear reactor building 130 is installed on the ground E. The nuclear reactor building 130 houses the nuclear reactor containment vessel 120 that accommodates the nuclear reactor pressure vessel 110. As illustrated in Fig. 6, the nuclear reactor building 130 is integrated with the nuclear reactor containment vessel 120. The nuclear reactor building 130 may accommodate nuclear reactor facility components other than the nuclear reactor containment vessel 120.

The nuclear reactor building 130 is formed of reinforced concrete. In the second embodiment, the nuclear reactor building 130 is formed using the neutron radiation shielding material of the present embodiment. In this case, the shielding material for the nuclear reactor can be mixed with concrete constituting the nuclear reactor building 130.

Since the shielding material for the nuclear reactor of the present embodiment is formed of the neutron radiation shielding material of the present embodiment as described above, the shielding material for the nuclear reactor can efficiently shield neutron radiation. Therefore, the shielding material for the nuclear reactor formed of the neutron radiation shielding material of the present embodiment can protect the human body from the effects of neutron radiation while using a small amount of the shielding material.

Since the nuclear reactor containment vessel 120 of the present embodiment is formed using the shielding material for the nuclear reactor of the present embodiment as described above, neutron radiation generated inside the nuclear reactor containment vessel 120 can be efficiently shielded. Therefore, the nuclear reactor containment vessel 120 of the present embodiment can protect the human body from the effects of neutron radiation while using a small amount of the shielding material for the nuclear reactor used.

Since the nuclear reactor building 130 of the present embodiment is constructed using the shielding material for the nuclear reactor of the present embodiment as described above, neutron radiation generated inside the nuclear reactor building 130 can be efficiently shielded. Therefore, the nuclear reactor building 130 of the present embodiment can protect the human body from the effects of neutron radiation while using a small amount of the building material.

<Third embodiment>

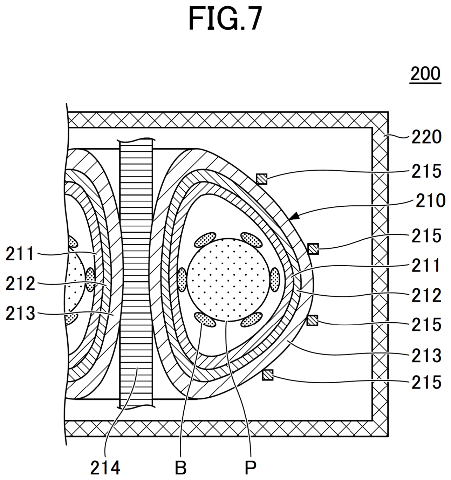

Fig. 7 illustrates one example of a nuclear fusion reactor facility in which the neutron radiation shielding material of the present embodiment is applied as a shielding material for a nuclear fusion reactor. In Fig. 7, the illustration is partially omitted. The neutron radiation shielding material of the present embodiment can constitute, for example, a shielding material for nuclear fusion, which shields neutron radiation generated in a nuclear fusion reactor. Specifically, the shielding material for the nuclear fusion reactor of the present embodiment can be composed of the neutron radiation shielding material that includes a boride and has a particle size of 500 $\mu$m or less.

In the present specification, nuclear fusion refers to a nuclear reaction in which light atomic nuclei are fused to each other to form a heavy atomic nucleus. For example, in a nuclear fusion reaction where atomic nuclei of deuterium (D) and tritium (T), which are isotopes of hydrogen, are fused, helium and neutrons are generated. In addition, the nuclear fusion reactor refers to a reactor that brings plasma to an ultra-high temperature state inside the ultra-high vacuum reactor to induce a nuclear fusion reaction, converts the energy created by the reactor to heat, and extracts the heat.

Nuclear fusion reactors are roughly classified into a magnetic confinement system and an inertial confinement system. Examples of the magnetic confinement system include tokamak-type nuclear fusion reactors, helical-type nuclear fusion reactors, field-reversed configuration-type nuclear fusion reactors, and the like. Examples of the inertial confinement system include laser-type nuclear fusion reactors, and the like. As one example of the nuclear fusion reactor of the present embodiment, a tokamak-type nuclear fusion reactor, which has been employed for International Thermonuclear Experimental Reactor (ITER), will be described.

The nuclear fusion reactor facility is a facility equipped with a nuclear fusion reactor. In Fig. 7, the nuclear fusion reactor facility 200 includes a nuclear fusion reactor main body 210 and a nuclear fusion reactor building 220.

The nuclear fusion reactor main body 210 includes a blanket 211, a vacuum vessel 212, a toroidal field (TF) coil 213, a central solenoid (CS) coil 214, and a poloidal field (PF) coil 215.

The blanket 211 is a doughnut-shaped wall surrounding the plasma P in the nuclear fusion reactor. For example, the blanket 211 is composed of approximately 400 blocks each formed of reduced activation ferritic steel having a thickness of approximately 50 cm. The blanket 211 has the height of approximately 7 m, the outer diameter of approximately 16 m, and the volume of approximately 800 $m^3$. The blanket 211 converts the nuclear fusion output into heat to take the heat out, and moreover a tritium fuel increase test is performed in part of the blanket (test blanket module) in addition to the extraction of heat.

A diverter (not illustrated) is provided to a lower portion of the blanket 211. The diverter is a portion that receives a high heat flow or a flow of particles from the plasma P in the blanket 211.

The vacuum vessel 212 is a vessel that surrounds the plasma P, the blanket 211, and the diverter to maintain an ultra-high vacuum.

The TF coil 213 is a superconducting coil provided outside the vacuum vessel 212. When a current is applied to the TF coil 213, a magnetic field B is generated. Each TF coil 213 weighs approximately 300 tons. Eighteen TF coils 213 are arranged in circle to create the strong magnetic field B in a doughnut-shaped space, thereby confining the plasma P.

The CS coil 214 is a superconducting coil arranged at the center of the doughnut-shaped TF coil 213. When a current is applied to the CS coil 214, a large current flows through the plasma P. Specifically, the CS coil 214 constitutes a secondary coil in which the plasma P is wound once.

The PF coil 215 is a circular superconducting coil provided outside the vacuum vessel 212. The PF coil 215 is configured to control a shape or position of the plasma P. In the present embodiment, four PF coils 215 are horizontally arranged in total.

The shielding material for the nuclear fusion reactor of the present embodiment is used in the nuclear fusion reactor main body 210. A portion of the nuclear fusion reactor main body 210 in which the shielding material for nuclear fusion reactor is used is not particularly limited, and is, for example, the blanket 211, the vacuum vessel 212, or the like. The nuclear fusion reactor main body 210 is one example of the nuclear fusion reactor of the present embodiment.

The nuclear fusion reactor building 220 houses the nuclear fusion reactor main body 210. As illustrated in Fig. 7, the nuclear fusion reactor building 220 is constructed integrally with the nuclear fusion reactor main body 210. The nuclear fusion reactor building 220 may accommodate nuclear fusion reactor facility components other than the nuclear fusion reactor main body 210.

The nuclear fusion reactor building 220 is formed of reinforced concrete. In the third embodiment, the nuclear fusion reactor building 220 is constructed using the shielding material for the nuclear fusion reactor of the present embodiment. In this case, the shielding material for the nuclear fusion reactor can be mixed with concrete constituting the nuclear fusion reactor building 220. The nuclear fusion reactor building 220 is one example of the nuclear fusion reactor building of the present embodiment.

Since the shielding material for the nuclear fusion reactor of the present embodiment is composed of the neutron radiation shielding material of the present embodiment as described above, neutron radiation can be efficiently shielded. Therefore, the shielding material for the nuclear fusion reactor formed of the neutron radiation shielding material of the present embodiment can protect the human body from the effects of neutron radiation while using a small amount of the shielding material.

Since the shielding material for the nuclear fusion reactor of the present embodiment is used in the nuclear fusion reactor of the present embodiment as described above, neutron radiation generated inside the nuclear fusion reactor main body 210 can be efficiently shielded. Therefore, the nuclear fusion reactor of the present embodiment can protect the human body from the effects of neutron radiation while using a small amount of the shielding material for the nuclear fusion reactor is used.

Since the nuclear fusion reactor building 220 of the present embodiment is constructed using the shielding material for the nuclear fusion reactor of the present embodiment as described above, neutron radiation generated inside the nuclear fusion reactor building 220 can be efficiently shielded. Therefore, the nuclear fusion reactor building 220 of the present embodiment can protect the human body from the effects of neutron radiation while using a small amount of a building material.

In the above-described embodiments, examples in which the neutron radiation shielding material is applied for a semiconductor device, a nuclear reactor facility, and a nuclear fusion reactor are described, but the present embodiment is not limited to the above embodiments, and may be used in various uses, such as transportation uses, medical uses, industrial uses, and the like.

Examples

The present embodiment will be further described through experimental examples hereinafter. Various tests and evaluations were performed according to the following methods.

[Neutron radiation shielding simulation]

Shielding performance of four neutron radiation sources (0.5 eV, 10 keV, 14 MeV, and 100 MeV) was evaluated using a neutron radiation shielding simulation calculation model under the following conditions.

[Simulation conditions]

Nuclear reaction model: INCL-4.2
Neutron reaction data (cross-section data): JENDL5.0 Neutron transport calculation (calculation code): MCNP Ver6.2.0
Calculating an attenuation ratio of the number of neutrons with varying a thickness of a material of Table 1
Calculating an attenuation ratio of the number of neutrons and the secondary radiation flux with varying a thickness of a material of Table 3
Secondary $\alpha$ rays: $\alpha$ rays generated by the reaction between neutrons and borophane
Secondary $\gamma$ rays: $\gamma$ rays generated by the reaction between neutrons and borophane

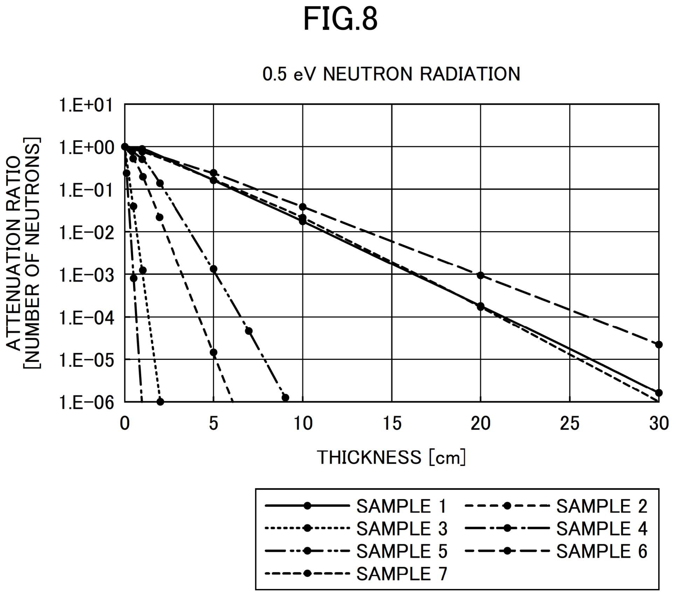

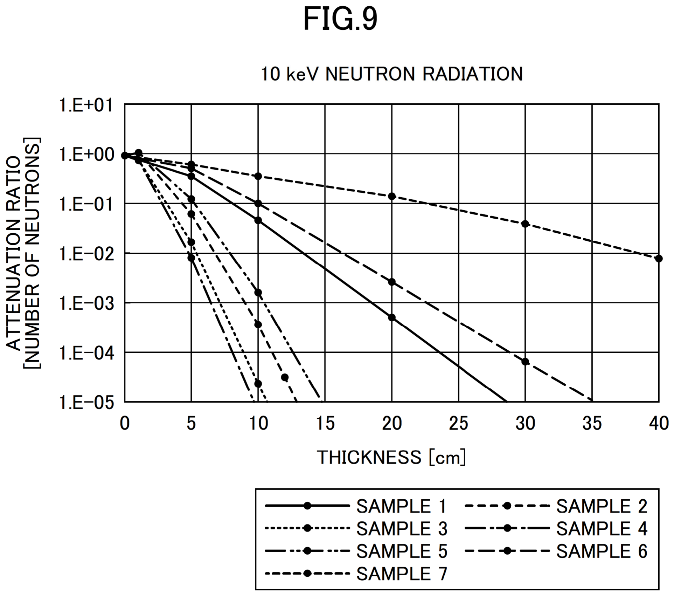

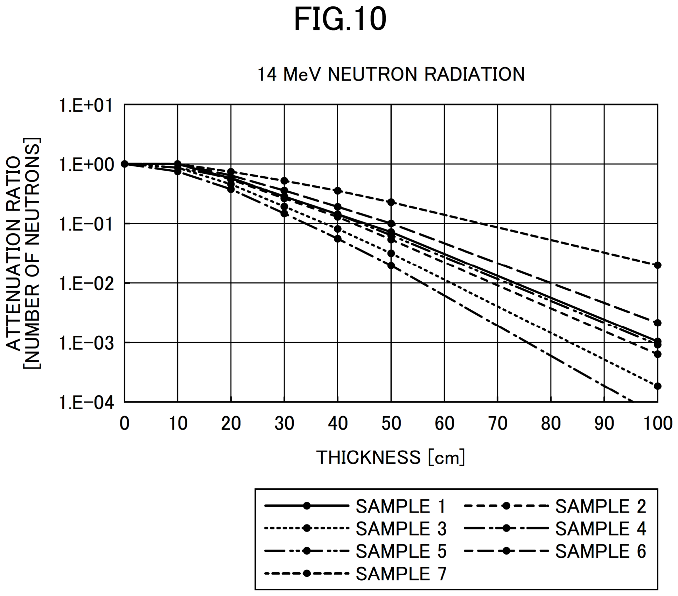

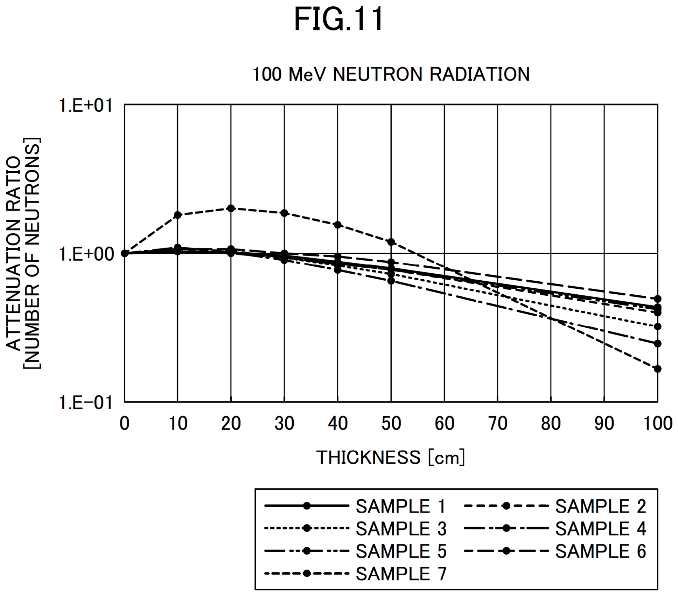

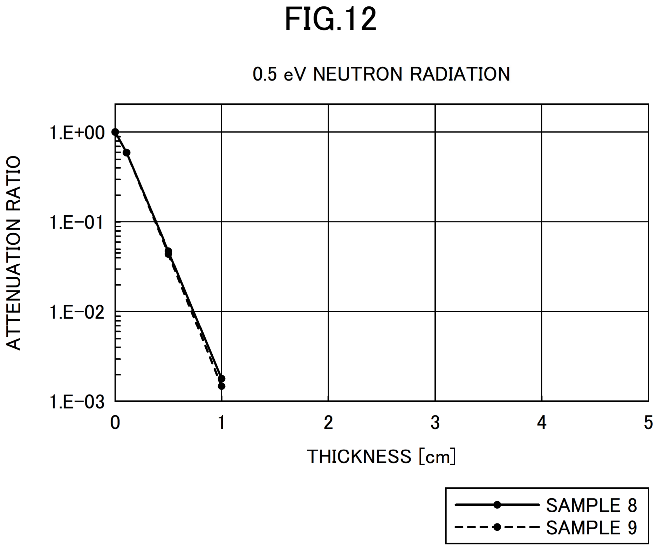

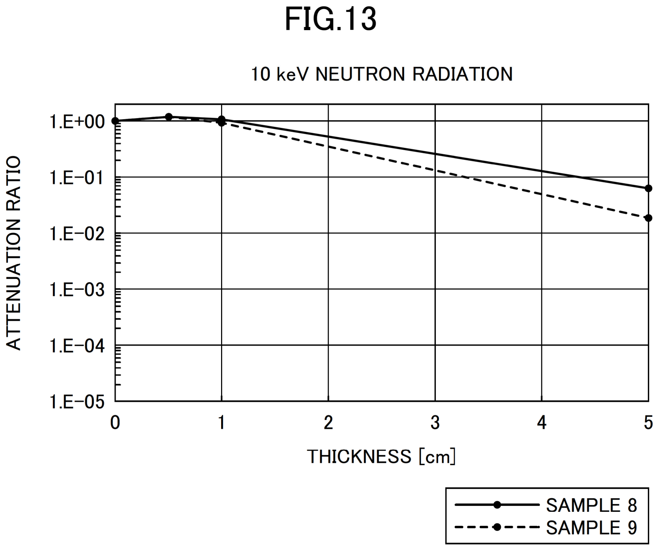

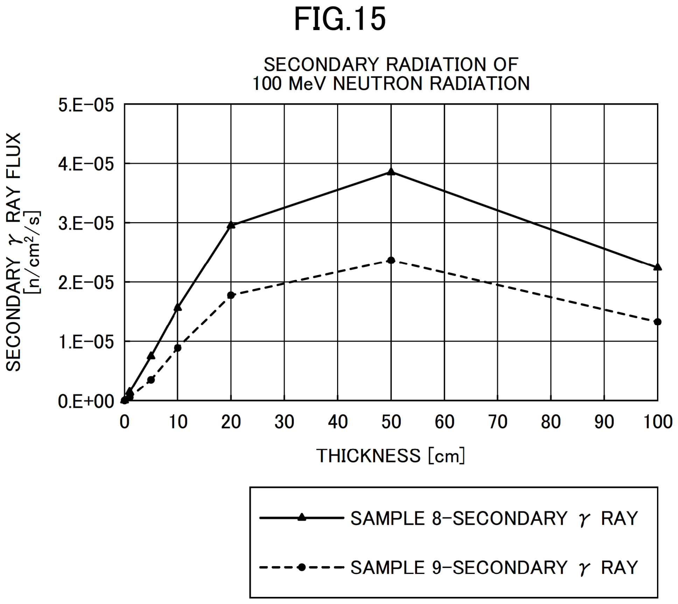

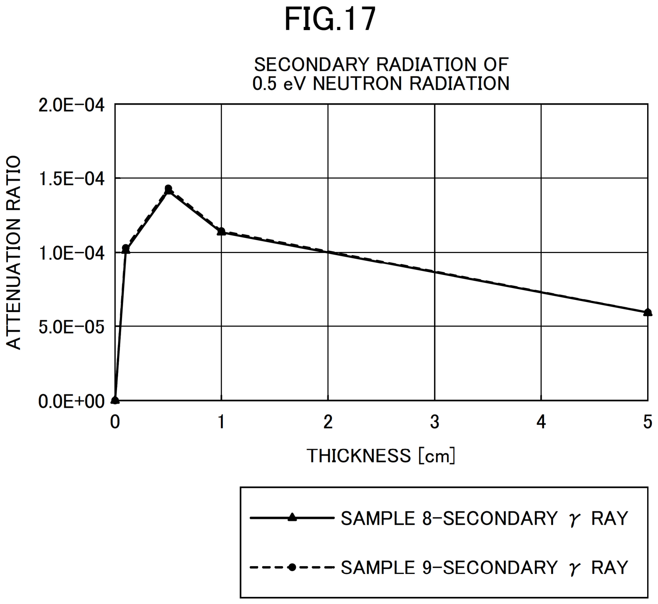

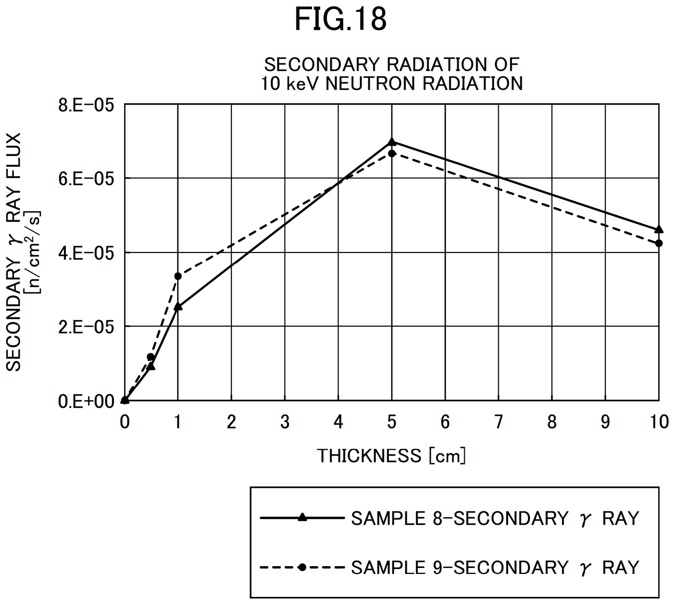

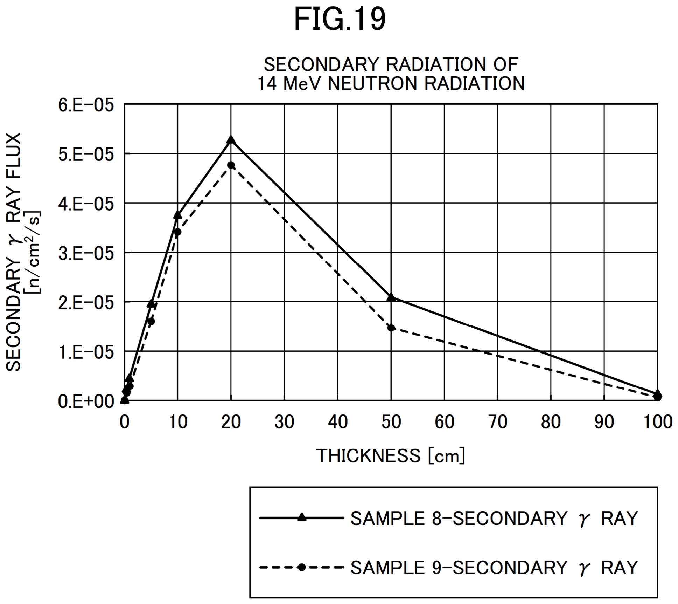

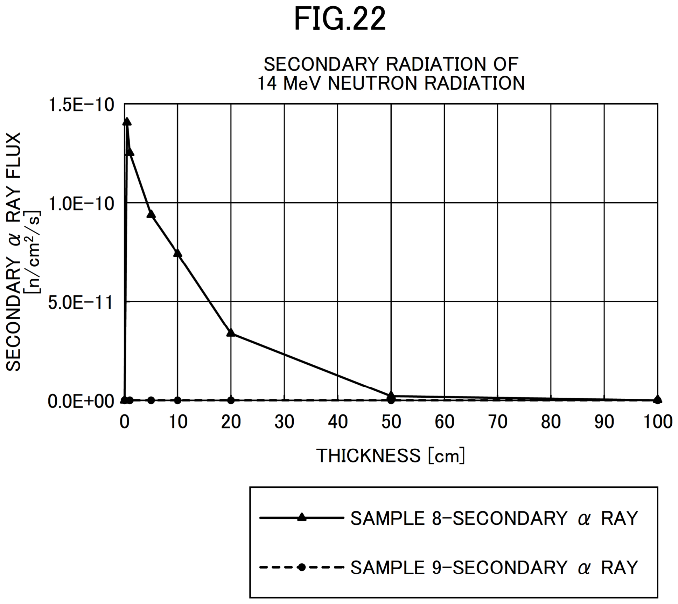

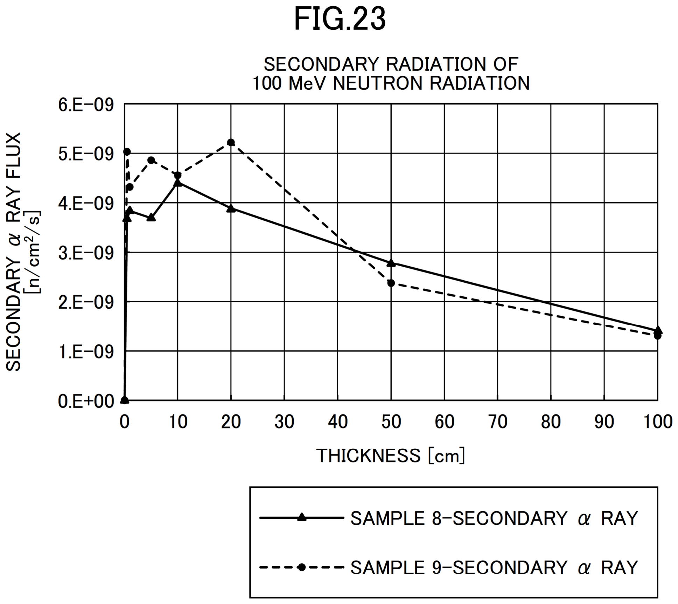

The conditions of Experiment Examples 1 to 7 are presented in Table 1, and corresponding evaluation results are presented in Table 2, and Figs. 8 to 11. In addition, the conditions of Experiment Examples 8 and 9 are presented in Table 3 below, and the corresponding evaluation results are presented in Figs. 12 to 23.

[Experiment Example 1]

A sheet (density: 0.935 g/cm$^3$) including 100 percent by mass of polyethylene (Material 2) was used.

[Experiment Example 2]

A sheet (density: 0.9885 g/cm$^3$) including 10 percent by mass of hydrogen boride (borophane) having an average particle diameter of 500 $\mu$m or less (Material 1) serving as a boride and 90 percent by mass of polyethylene (Material 2) was used.

[Experiment Example 3]

A sheet (density: 1.2025 g/cm$^3$) including 50 percent by mass of borophane having an average particle diameter of 500 $\mu$m or less (Material 1) serving as a boride and 50 percent by mass of polyethylene (Material 2) was used.

[Experiment Example 4]

A sheet (density: 1.47 g/cm$^3$) including 100 percent by mass of borophane having an average particle diameter of 500 $\mu$m or less (Material 1) serving as a boride was used.

[Experiment Example 5]

A sheet (density: 0.985 g/cm$^3$) including 10 percent by mass of B$_2$O$_3$ (Material 1) serving as a boron compound other than a boride and 90 percent by mass of polyethylene (Material 2) was used.

[Experiment Example 6]

A sheet (density: 1 g/cm$^3$) including 100 percent by mass of H$_2$O (Material 1) was used.

[Experiment Example 7]

A sheet (density: 7.812 g/cm$^3$) including 99 percent by mass of Fe (Material 1) and 1 percent by mass of polyethylene (Material 2) was used.

[Experiment Example 8]

A sheet (density: 1.2165 g/cm$^3$) including 50 percent by mass of borophane having an average particle diameter of 500 $\mu$m or less (Material 1) serving as a boride and 50 percent by mass of dimethylpolysiloxane (silicone resin) (Material 2) was used.

[Experiment Example 9]

A sheet (density: 1.1952 g/cm$^3$) including 50 percent by mass of borophane having an average particle diameter of 500 $\mu$m or less (Material 1) serving as a boride and 50 percent by mass of polyethylene (Material 2) was used.

[Table 1]

| No | Material 1 | Material 1 ratio (mass%) | Material 2 | Material 2 ratio (mass%) | Density (g/cm$^3$) |
|---|---|---|---|---|---|
| Experiment Example 1 | HB (hydrogen boride) | 0 | C$_2$H$_4$ (Polyethylene) | 100 | 0.935 |
| Experiment Example 2 | | 10 | | 90 | 0.9885 |
| Experiment Example 3 | | 50 | | 50 | 1.2025 |
| Experiment Example 4 | | 100 | | 0 | 1.47 |
| Experiment Example 5 | B$_2$O$_3$ | 10 | | 90 | 0.985 |
| Experiment Example 6 | H$_2$O | 100 | - | - | 1 |
| Experiment Example 7 | Fe | 99 | C | 1 | 7.812 |

[Table 2]

| Radiation source | Neutron shielding rate | | | | | | |
|---|---|---|---|---|---|---|---|
| | Experiment Example 1 | Experiment Example 2 | Experiment Example 3 | Experiment Example 4 | Experiment Example 5 | Experiment Example 6 | Experiment Example 7 |
| 0.5 eV (/1 cm) | - | - | 1.00E-03 | 1.00E-06 | - | - | - |
| 0.5 eV (/5 cm) | 2.00E-01 | 1.00E-05 | 1.00E-06 less | 1.00E-06 less | 1.00E-03 | 3.00E-01 | 2.00E-01 |
| 10 keV (/10 cm) | 5.00E-02 | 4.00E-04 | 2.00E-05 | 1.00E-05 | 1.00E-03 | 1.00E-01 | 4.00E-01 |
| 14 MeV (/100 cm) | 1.00E-03 | 8.00E-04 | 2.00E-04 | 1.00E-04 less | 1.00E-03 | 2.00E-03 | 2.00E-02 |
| 100 MeV (/100 cm) | 5.00E-01 | 5.00E-01 | 4.00E-01 | 3.00E-01 | 5.00E-01 | 6.00E-01 | 2.00E-01 |

[Table 3]

| No | Material 1 | Material 1 ratio (mass%) | Material 2 | Material 2 ratio (mass%) | Density (g/cm$^3$) |
|---|---|---|---|---|---|
| Experiment Example 8 | HB (hydrogen boride) | 50 | Polydimethyl siloxane (silicone resin) | 50 | 1.2165 |
| Experiment Example 9 | | | Polyethylene | | 1.1952 |

It was found from Tables 1 to 3, Experiment Examples 1 to 9, and Figs. 8 to 13 that the sheets including the boride having an average particle diameter of 500 $\mu$m or less had a higher neutron radiation shielding rate than the sheets that did not include the boride. From the above results, it can be expected that soft errors of a semiconductor device, which is caused by neutron radiation incident on the semiconductor device, can be inhibited by the neutron radiation shielding material using the boride.

In addition, it can be expected that the neutron radiation shielding material using the boride having an average particle diameter of 500 $\mu$m or less can protect the human body from the effects of neutron radiation while using a small amount of the neutron radiation shielding material. Further, it can be expected that the neutron radiation shielding material using the boride having an average particle diameter of 500 $\mu$m or less can be applied for a nuclear reactor facility, a nuclear fusion reactor facility, or the like , with which reduction in adverse effects to the human body is desired.

It was found from Tables 1 and 2, Experiment Examples 1 to 7, and Figs. 7 to 10 that the hydrogen boride sheets (borophane sheets), which included the boride having an average particle diameter of 500 $\mu$m or less, had a higher shielding rate of neutron radiation compared to the sheet that did not include hydrogen boride.

Further, it was found that the hydrogen boride sheets (borophane sheets) had a higher shielding rate of neutron radiation even in the low energy region (10 keV or less) compared to the sheet that did not include hydrogen boride. From the above results, it can be expected that soft errors of a semiconductor device having a high soft error rate can be inhibited by using the hydrogen boride sheet (borophane sheet) as a neutron radiation shielding material.

In addition, it was found from Table 2, and Experiment Examples 4, 5, and 6 that the theoretical density of the hydrogen boride sheet (borophane sheet) was 1.47 g/cm$^3$, which was higher than water (1.00 g/cm$^3$) or boron oxide + polyethylene (0.985 g/cm$^3$) available as a commercial product for shielding neutron radiation.

The actual density of the borophane that is compressed by a hydraulic press at 35 MPa for 15 minutes is 1.23 g/cm$^3$, which is a value close to the theoretical density. Therefore, it is highly possible that the comparable performance can be exhibited in the actual neutron radiation shielding evaluation.

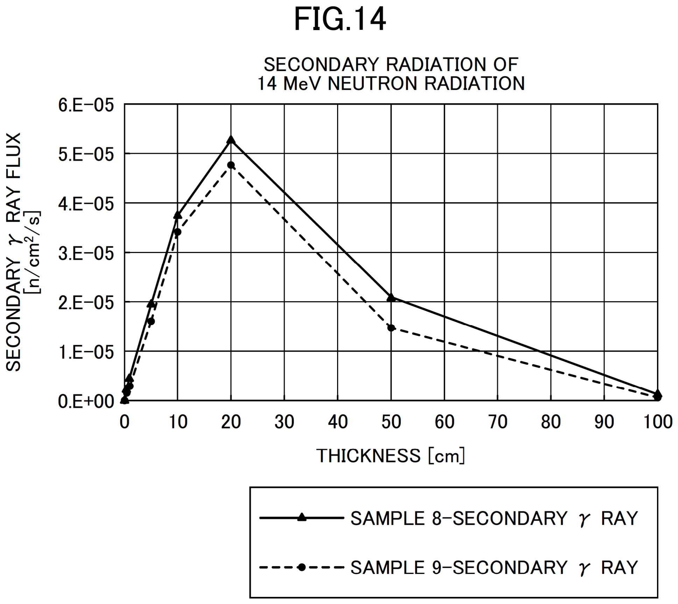

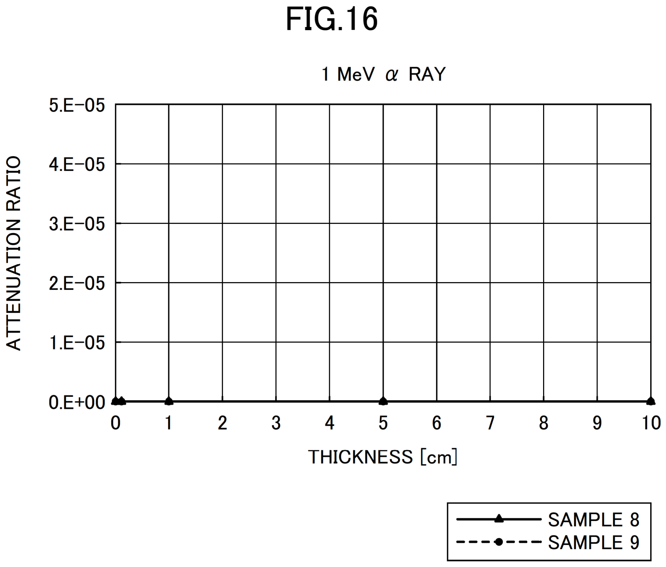

Further, it was found from Table 3, Experiment Examples 8 and 9, and Figs. 14 to 23 that the sheets including the boride having an average particle diameter of 500 $\mu$m or less shield $\alpha$ rays and $\gamma$ rays as radioactive rays other than the neutron radiation. In particular, it was found from Fig. 16 that the sheets including the boride could shield $\alpha$ rays even when the thickness of the sheet was not large.

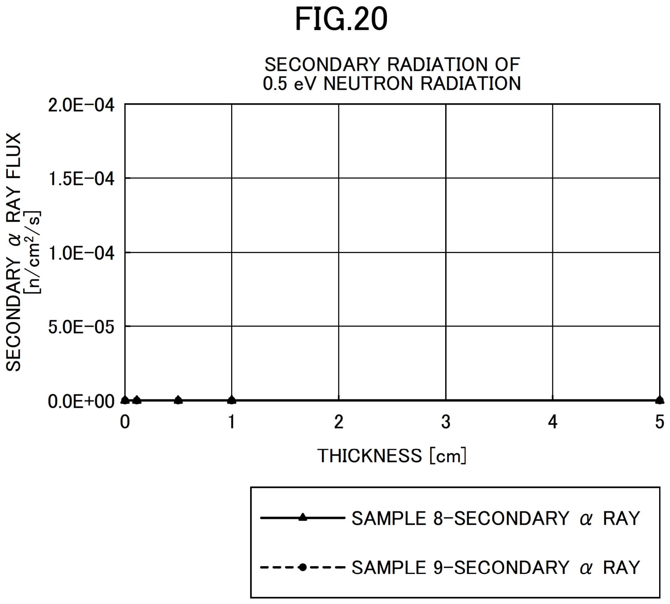

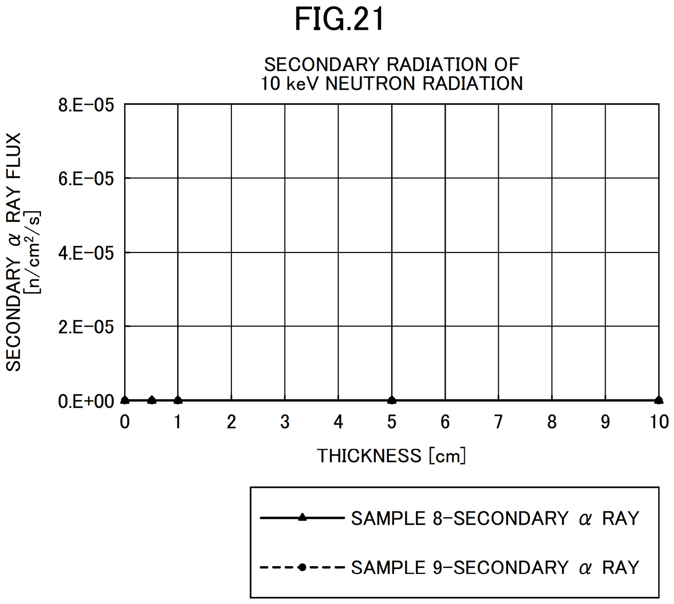

It was found from Table 3, Experiment Examples 8 and 9, and Figs. 14, 15, and 18 to 23 that the sheets including the boride having an average particle diameter of 500 $\mu$m or less inhibited generation of secondary radiation. In particular, it was found from Figs. 20 and 21 that the sheets including the boride generated almost no secondary $\alpha$ rays even when neutron radiation of 10.0 keV was applied.

The present embodiment disclosed above includes, for example, the following embodiments.

(Clause 1)

A neutron radiation shielding material, including:

a boride having an average particle diameter of 500 $\mu$m or less,
wherein the neutron radiation shielding material shields neutron radiation.

(Clause 2)

The neutron radiation shielding material according to clause 1,
wherein an energy region of the neutron radiation is 100 MeV or less.

(Clause 3)

The neutron radiation shielding material according to clause 1 or 2,

wherein an amount of the boride is 5 percent by mass or greater.

(Clause 4)

The neutron radiation shielding material according to any one of clauses 1 to 3,
wherein the neutron radiation shielding material is sheet shaped.

(Clause 5)

The neutron radiation shielding material according to clause 4,
wherein the sheet has a thickness of 1 nm or greater and 1,000 $\mu$m or less.

(Clause 6)

The neutron radiation shielding material according to any one of clauses 1 to 5, further including:
a resin.

(Clause 7)

The neutron radiation shielding material according to any one of clauses 1 to 6,
wherein the neutron radiation shielding material is a layer stack in which at least a first layer including the boride and a second layer including a resin are stacked.

(Clause 8)

A shielding material for a semiconductor device, including:

the neutron radiation shielding material of any one of clauses 1 to 7 being used to form the shielding material for the semiconductor device,
wherein the shielding material for the semiconductor device shields neutron radiation applied to the semiconductor device.

(Clause 9)

A package for a semiconductor device, including:

the shielding material for the semiconductor device of clause 8 being used to form the package for the semiconductor device,
wherein a semiconductor element is accommodated in the package for the semiconductor device.

(Clause 10)

A shielding material for a nuclear reactor, including:

the neutron radiation shielding material of any one of clauses 1 to 7 being used to form the shielding material for the nuclear reactor,
wherein the shielding material for the nuclear reactor shields neutron radiation generated in the nuclear reactor.

(Clause 11)

A nuclear reactor containment vessel including:

the shielding material for the nuclear reactor of clause 10 being used to form the nuclear reactor containment vessel,
wherein the nuclear reactor containment vessel accommodates a nuclear reactor pressure vessel.

(Clause 12)

A nuclear reactor building including:

the shielding material for the nuclear reactor of clause 10 being used to construct the nuclear reactor building, wherein the nuclear reactor building houses a nuclear reactor containment vessel in which a nuclear reactor pressure vessel is accommodated.

(Clause 13)

A shielding material for a nuclear fusion reactor, including:

the neutron radiation shielding material of any one of clauses 1 to 7 being used to form the shielding material for the nuclear fusion reactor,
wherein the shielding material for the nuclear fusion reactor shields neutron radiation generated in the nuclear fusion reactor.

(Clause 14)

A nuclear fusion reactor including:
the shielding material for the nuclear fusion reactor of clause 13 being used in the nuclear fusion reactor.

(Clause 15)

A nuclear fusion reactor building including:
the shielding material for the nuclear fusion reactor of clause 13 being used to construct the nuclear fusion reactor building.
Although the embodiments of the present invention have been described above, the present invention is not limited to the specific embodiments, and various modifications and changes can be made within the scope of the invention as described in the claims.
The present application claims priority based on Japanese Patent Application No. 2023-078396, filed on May 11, 2023, and Japanese Patent Application No. 2024-076763, filed on May 9, 2024, the entire content of which are incorporated herein by reference.

REFERENCE SIGNS LIST

| | |
|---|---|
| 1 | semiconductor device |
| 2 | semiconductor element |
| 3 | housing (package) |
| 3A | bottom |
| 3B | insertion portion |
| 10 | printed circuit board |
| 20 | SRAM |
| 21, 22 | core (SoC) |
| 23, 24 | HBM (SoC) |
| 25 | TIM |
| 30 | heat sink |
| 40 | FPGA die |
| 41, 42 | silicon die |
| 43 | TIM |
| 50 | optical transceiver |
| 51 | TIM |
| 60 | heat spreader |
| 70 | transmission cable |
| 100 | nuclear reactor facility |
| 110 | nuclear reactor pressure vessel |
| 111 | water inlet |
| 112 | exhaust outlet |
| 120 | nuclear reactor containment vessel |
| 130 | nuclear reactor building |
| 140 | core shroud |

| 150 | steam separator |
|---|---|
| 160 | steam dryer |
| 170 | fuel rod |
| 180 | control rod |
| 190 | support member |
| E | ground |
| 200 | nuclear fusion reactor facility |
| 210 | nuclear fusion reactor main body |
| 211 | blanket |
| 212 | vacuum vessel |
| 213 | toroidal field (TF) coil |
| 214 | central solenoid (CS) coil |
| 215 | poloidal field (PF) coil |
| P | plasma |
| B | magnetic field |
| 220 | nuclear fusion reactor building |

**Claims**

1. A neutron radiation shielding material, comprising:
   a boride having an average particle diameter of 500 $\mu$m or less,
   wherein the neutron radiation shielding material shields neutron radiation.

2. The neutron radiation shielding material according to claim 1,
   wherein an energy region of the neutron radiation is 100 MeV or less.

3. The neutron radiation shielding material according to claim 1,
   wherein an amount of the boride is 5 percent by mass or greater.

4. The neutron radiation shielding material according to claim 1,
   wherein the neutron radiation shielding material is sheet shaped.

5. The neutron radiation shielding material according to claim 4,
   wherein the sheet has a thickness of 1 nm or greater and 1,000 $\mu$m or less.

6. The neutron radiation shielding material according to claim 1, further comprising:
   a resin.

7. The neutron radiation shielding material according to claim 1,
   wherein the neutron radiation shielding material is a layer stack in which at least a first layer including the boride and a second layer including a resin are stacked.

8. A shielding material for a semiconductor device, comprising:

   the neutron radiation shielding material of any one of claims 1 to 7 being used to form the shielding material for the semiconductor device,
   wherein the shielding material for the semiconductor device shields neutron radiation applied to the semiconductor device.

9. A package for a semiconductor device, comprising:
   the shielding material for the semiconductor device of claim 8 being used to form the package for the semiconductor device,
   wherein a semiconductor element is accommodated in the package for the semiconductor device.

10. A shielding material for a nuclear reactor, comprising:
    the neutron radiation shielding material of any one of claims 1 to 7 being used to form the shielding material for the nuclear reactor,
    wherein the shielding material for the nuclear reactor shields neutron radiation generated in the nuclear reactor.

**11.** A nuclear reactor containment vessel, comprising:
the shielding material for the nuclear reactor of claim 10 being used to form the nuclear reactor containment vessel,
wherein the nuclear reactor containment vessel accommodates a nuclear reactor pressure vessel.

**12.** A nuclear reactor building, comprising:
the shielding material for the nuclear reactor of claim 10 being used to construct the nuclear reactor building,
wherein the nuclear reactor building houses a nuclear reactor containment vessel in which a nuclear reactor pressure vessel is accommodated.

**13.** A shielding material for a nuclear fusion reactor, comprising:
the neutron radiation shielding material of any one of claims 1 to 7 being used to form the shielding material for the nuclear fusion reactor,
wherein the shielding material for the nuclear fusion reactor shields neutron radiation generated in the nuclear fusion reactor.

**14.** A nuclear fusion reactor comprising:
the shielding material for the nuclear fusion reactor of claim 13 being used in the nuclear fusion reactor.

**15.** A nuclear fusion reactor building including:
the shielding material for the nuclear fusion reactor of claim 13 being used to construct the nuclear fusion reactor building.

FIG.1

# FIG.2

# FIG.3

# FIG.4

326 $\mu$ m

200 $\mu$ m

# FIG.5

EP 4 712 132 A1

# FIG.6

# FIG.7

200

220
215
210
215
211
212
215
213
215

211
212
213

214    B    P

# FIG.8

## 0.5 eV NEUTRON RADIATION

# FIG.9

10 keV NEUTRON RADIATION

# FIG.10

14 MeV NEUTRON RADIATION

# FIG.11

## 100 MeV NEUTRON RADIATION

ATTENUATION RATIO [NUMBER OF NEUTRONS] vs THICKNESS [cm]

Legend:
SAMPLE 1 — SAMPLE 2
SAMPLE 3 — SAMPLE 4
SAMPLE 5 — SAMPLE 6
SAMPLE 7

# FIG.12

## 0.5 eV NEUTRON RADIATION

# FIG.13

### 10 keV NEUTRON RADIATION

# FIG.14

SECONDARY RADIATION OF
14 MeV NEUTRON RADIATION

SAMPLE 8-SECONDARY γ RAY

SAMPLE 9-SECONDARY γ RAY

# FIG.15

SECONDARY RADIATION OF
100 MeV NEUTRON RADIATION

# FIG.16

**1 MeV α RAY**

# FIG.17

**SECONDARY RADIATION OF
0.5 eV NEUTRON RADIATION**

Legend:
- SAMPLE 8-SECONDARY γ RAY
- SAMPLE 9-SECONDARY γ RAY

# FIG.18

SECONDARY RADIATION OF
10 keV NEUTRON RADIATION

# FIG.19

SECONDARY RADIATION OF
14 MeV NEUTRON RADIATION

# FIG.20

SECONDARY RADIATION OF
0.5 eV NEUTRON RADIATION

# FIG.21

### SECONDARY RADIATION OF
### 10 keV NEUTRON RADIATION

SECONDARY α RAY FLUX [n/cm²/s]

THICKNESS [cm]

SAMPLE 8-SECONDARY α RAY

SAMPLE 9-SECONDARY α RAY

# FIG.22

SECONDARY RADIATION OF
14 MeV NEUTRON RADIATION

# FIG.23

SECONDARY RADIATION OF
100 MeV NEUTRON RADIATION

SAMPLE 8—SECONDARY $\alpha$ RAY

SAMPLE 9—SECONDARY $\alpha$ RAY

## INTERNATIONAL SEARCH REPORT

International application No.

**PCT/JP2024/017539**

| A. | CLASSIFICATION OF SUBJECT MATTER |
|---|---|

*H01L 23/02*(2006.01)i; *G21F 1/10*(2006.01)i; *G21F 3/00*(2006.01)i; *H05K 9/00*(2006.01)i
FI:  H01L23/02 A; H05K9/00 X; G21F1/10; G21F3/00 N

According to International Patent Classification (IPC) or to both national classification and IPC

| B. | FIELDS SEARCHED |
|---|---|

Minimum documentation searched (classification system followed by classification symbols)

H01L23/02; G21F1/10; G21F3/00; H05K9/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2004-151096 A (COGEMA LOGISTICS) 27 May 2004 (2004-05-27)<br>paragraphs [0006], [0007], [0066] | 1-15 |
| Y | JP 2021-178953 A (SAMSUNG SDI CO., LTD.) 18 November 2021 (2021-11-18)<br>paragraphs [0002]-[0004], [0036], [0069] | 1-15 |
| Y | JP 2012-225749 A (KUMAZAWA, Noboru) 15 November 2012 (2012-11-15)<br>paragraphs [0032], [0040], [0045] | 4, 5, 7 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 June 2024** | **18 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

| International application No. |
| --- |
| **PCT/JP2024/017539** |

| Patent document cited in search report | | | Publication date (day/month/year) | Patent family member(s) | | | Publication date (day/month/year) |
| --- | --- | --- | --- | --- | --- | --- | --- |
| JP | 2004-151096 | A | 27 May 2004 | US | 2004/0127599 | A1 | |
| | | | | paragraphs [0012], [0016], [0107] | | | |
| | | | | EP | 1418593 | A1 | |
| | | | | FR | 2846467 | A1 | |
| JP | 2021-178953 | A | 18 November 2021 | US | 2021/0355344 | A1 | |
| | | | | paragraphs [0003], [0040], [0088] | | | |
| | | | | KR | 10-2021-0141881 | A | |
| | | | | CN | 113667433 | A | |
| | | | | TW | 202142622 | A | |
| JP | 2012-225749 | A | 15 November 2012 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021178953 A
- JP 2021181559 A
- JP 2014137361 A
- JP 2023078396 A
- JP 2024076763 A